(19) Europäisches Patentamt / European Patent Office / Office européen des brevets

(11) **EP 2 983 207 B1**

(12) **EUROPEAN PATENT SPECIFICATION**

(45) Date of publication and mention of the grant of the patent:
**14.04.2021 Bulletin 2021/15**

(21) Application number: **13828969.9**

(22) Date of filing: **28.04.2013**

(51) Int Cl.:
*H01L 27/32* (2006.01)   *H01L 21/77* (2017.01)

(86) International application number:
**PCT/CN2013/074954**

(87) International publication number:
**WO 2014/153801 (02.10.2014 Gazette 2014/40)**

(54) **ORGANIC ELECTROLUMINESCENT ARRAY SUBSTRATE, MANUFACTURING METHOD THEREOF AND DISPLAY DEVICE**

ORGANISCHES ELEKTROLUMINESZENZARRAYSUBSTRAT, VERFAHREN ZUR HERSTELLUNG DAVON UND ANZEIGEVORRICHTUNG

SUBSTRAT DE MATRICE ÉLECTROLUMINESCENT ORGANIQUE, SON PROCÉDÉ DE FABRICATION ET DISPOSITIF D'AFFICHAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2013 CN 201310109108**

(43) Date of publication of application:
**10.02.2016 Bulletin 2016/06**

(73) Proprietor: **BOE Technology Group Co., Ltd.**
**Beijing 100015 (CN)**

(72) Inventors:
• **CHEN, Haijing**
  **Beijing, 100176 (CN)**
• **CHENG Jun**
  **Beijing, 100176 (CN)**
• **JIANG, Chunsheng**
  **Beijing, 100176 (CN)**
• **SHEN, Wulin**
  **Beijing, 100176 (CN)**

(74) Representative: **Klunker IP**
**Patentanwälte PartG mbB**
**Destouchesstraße 68**
**80796 München (DE)**

(56) References cited:
**EP-A2- 1 032 045       EP-A2- 1 758 170**
**EP-A2- 2 472 583       WO-A1-2012/132862**
**CN-A- 1 612 024        CN-A- 1 836 188**
**CN-A- 101 750 779      JP-A- 2006 244 892**
**US-A1- 2004 046 725    US-A1- 2004 051 448**
**US-A1- 2005 140 906    US-A1- 2006 114 190**
**US-A1- 2010 117 528    US-A1- 2012 313 844**

**Description**

TECHNICAL FIELD

The present invention relates to an organic electroluminescence array substrate, a manufacturing method thereof and a display device.


BACKGROUND

Compared with liquid crystal displays (LCDs), organic electroluminescence displays are a kind of self-illumination displays with high contrast ratio and wide viewing angle. Organic electroluminescence (EL) displays have a plurality of advantages, such as self-illumination, fast response speed, wide viewing angle, and capability of being applied to flexible display, transparent display, three-dimensional (3D) display and the like.

An organic EL display is generally formed as follows: sub-pixels for emitting red light, green light and blue light respectively are arranged into pixels, and the pixels are in turn arranged to form a matrix and hence form the organic electroluminescence display. The luminous efficiency of organic EL devices for emitting red light, green light and blue light is different from each other; and the organic EL devices for emitting red light and green light have higher luminous efficiency but the organic EL device for emitting blue light has lower luminous efficiency and shorter service life as well. In order to make the display to normally display white light, the three kinds of organic EL devices must be matched correspondingly: for instance, the electric current supplied to the organic EL device for emitting blue light may be increased in such a way that the brightness of blue light can be matched with that of red light and green light. However, the increase of the electric current can reduce the service life of the organic EL devices and hence reduce the service life of the display.

In order to not affect the service life of a display, in the known technology, the effective light-emitting area of an organic EL device for emitting blue light is often increased in such a way that the brightness of blue light can be matched with that of red light and green light. However, in the design of sub-pixels of the traditional display, both the length and the width of a red sub-pixel, a green sub-pixel and a blue sub-pixel are the same accordingly. In this case, when the effective light-emitting area of the blue sub-pixel is increased, it means that the effective light-emitting areas of the red sub-pixel and the green sub-pixel are each less than that of the blue sub-pixel, and hence the red sub-pixel and the green sub-pixel are certainly provided with regions which do not emit light while do not belong to opaque circuit areas, and consequently the aperture ratio of the red sub-pixel and the green sub-pixel is reduced.

US 2004/051448 A1 discloses an EL display device and pattern layout method for the same, in which to adjust for differences in service life among light emissive materials used for respective colors by determining the length of a pixel region in the row direction according to the service lives of the light emissive materials, and in which to allow for material change after completion of the laying out process, a light emitting region is formed such that a margin is ensured in the row or column direction within each pixel region.

EP 1 032 045 A2 discloses a color display device having an organic EL element for each display pixel. The element emissive area in the display pixel of any color among the R, G, and B display pixels has a size that is different from the element emissive area of the display pixel of another color. Furthermore, the element emissive areas in the display pixels for R, G, and B are designed to take into consideration not only the emission efficiency of the emissive elements of the display pixels but also the luminance ratio of red to green to blue in accordance with the chromaticity of the target display white of the display device and with the chromaticity of each red, green, and blue color emitted by the emissive elements of the respective display pixels.

US 2010/117528 A1 discloses a display device including: a pair of substrates in which a plurality of pixels are disposed in a matrix form as a whole, the pixels being configured with pixels corresponding to R (red), G (green), or B (blue), and the pixels corresponding to the R, G, or B having size different from each other; a self-luminous photo-emission element formed in a region corresponding to each of the pixels, on one of the pair of substrates; and a black matrix layer formed in a region corresponding to among the pixels, on the other of the pair of substrates.

EP 1 758 170 A2 discloses an organic light emitting display and a method for fabricating the same, in which a layout of respective pixels is changed in order to improve life span so that one pixel region having low luminous efficiency is increased. The organic light emitting display includes at least one pixel comprising sub pixels having a plurality of colors. A first sub pixel emission layer is formed over an entire surface of a pixel region. At least two second sub pixel emission layers are formed at the first sub pixel emission layer so as to have a closed curve. The layout of respective pixels is changed so as to increase an area of one sub pixel region having low luminous efficiency.

US 2006/114190 A1 discloses an active matrix organic EL device array comprising first sub-pixel regions and second sub-pixel regions defined by scan lines and data lines. Each first sub-pixel region has a first light emitting device, a first control unit and a second control unit therein while each second sub-pixel region has a second light emitting device therein. The first control unit is electrically connected to the first light emitting device for driving the first light emitting device. The second control unit is electrically connected to the second light emitting device for driving the second light emitting device. The second light emitting device having poor light emitting efficiency per unit area is disposed in the second sub-pixel region for increasing its light emitting area so that the first and second light emitting devices may have uniform brightness when drive with the same driving current.

WO 2012/132862 A1 discloses an organic EL display and a method for manufacturing the organic EL display, in which a light-emission area is controlled by sectioning off a first electrode by a first partition into at least two different aperture areas, and in which the area ratio between the maximum aperture area and the minimum aperture area sectioned off by a second partition is set below the area ratio between the maximum aperture area and the minimum aperture area sectioned off by the first partition, whereby the aperture area sectioned off by the second partition of each color is made as consistent as possible.

US 2012/313844 A1 discloses an organic light-emitting display device includes a substrate, a plurality of pixel electrodes arranged in a matrix on the substrate, and an organic common layer covering the pixel electrodes. The pixel electrodes include a plurality of first pixel electrodes, a plurality of second pixel electrodes, and a plurality of third pixel electrodes. An n-th pixel column includes the second pixel electrodes and the third pixel electrodes arranged alternately, an (n+1)-th pixel column which is adjacent to the n-th pixel column includes the first pixel electrodes, and an (n+2)-th pixel column which is adjacent to the (n+1)-th pixel column includes the second pixel electrodes and the third pixel electrodes arranged alternately, wherein n is a natural number.; One of the second and third pixel electrodes is disposed in the n-th pixel column in a row and the other one of the second and third pixel electrodes is disposed in the (n+2)-th pixel column in the same row.

EP 2 472 583 A2 discloses a display device built on an insulating substrate suitable for processing on both sides that includes a plurality of conductive through-holes through the substrate. One side is reserved for a high-density array of OLEDs. The OLEDs are provided with a high-density because the electrical connections for the OLEDs are on the other side of the substrate and interconnected via the conductive through-holes. The cathode sides of the OLEDs are interconnected by a light transmitting layer overlaying the cathode side that is electrical conductive. On the side of the substrate opposite the OLEDs is an array of anode contacts configured to form an electrical contact with a driver circuit.

JP 2006 244892 A discloses an active-matrix organic EL device array comprising a first and second subpixel areas determined with scanning lines and data lines is provided. Each first subpixel area has a first light emitting element, a first control unit and a second control unit. Each second subpixel area has a second light emitting element. The first control unit is electrically connected with the first light emitting element to drive the first light emitting element. The second control unit is electrically connected with the second light emitting element to drive the second light emitting element. The second light emitting element with low light emitting efficiency per unit area is disposed in the second subpixel area so that the first and the second light emitting elements have uniform luminance and their light emitting surface areas are increased when driven by the same drive current.

SUMMARY

It is an object of the present invention to provide an organic electroluminescence array substrate, a manufacturing method thereof and a display device, for which the aperture ratio of the organic electroluminescence array substrate can be increased.

The object is achieved by the features of the respective independent claims. Further embodiments are defined in the respective dependent claims.

BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.

FIG. 1 is a schematic diagram illustrating the arrangement of an organic electroluminescence array substrate in the traditional display device;

FIG. 2 is a schematic diagram illustrating the arrangement of an organic electroluminescence array substrate in the embodiment of the present invention; and

FIG. 3 is a schematic diagram of a display device in the embodiment of the present invention.

Reference numerals in accompanying drawings:

| | |
|---|---|
| 101 Scanning Line | 102 Data Line |
| 103 Power Line | 104 Opaque Circuit Area |
| 105 Anode of the organic electroluminescence device | |
| 106 Organic electroluminescence device | 107 Red Sub-pixel |
| 108 Green Sub-pixel | 109 Blue Sub-pixel |

DETAILED DESCRIPTION

For more clear understanding of the objectives, technical proposals and advantages of the embodiments of the present invention, clear and complete description will be given below to the technical proposals of the embodiments of the present invention with reference to the accompanying drawings of the embodiments of the present invention. It will be obvious to those skilled in the art that the preferred embodiments are only partial embodiments of the present invention but not all the embodiments.

With respect to the problem of low aperture ratio of red sub-pixels and green sub-pixels in a traditional organic electroluminescence display, embodiments of the present invention provide an organic electroluminescence array substrate, a manufacturing method thereof and a display device, in which the aperture ratio of the organic electroluminescence array substrate can be increased.

An embodiment of the present invention provides an organic electroluminescence array substrate, which comprises the features of claim 1.

The lengths of the red sub-pixel, the green sub-pixel and the blue sub-pixel may be the same; and both a width of the red sub-pixel and a width of the green sub-pixel are less than a width of the blue sub-pixel.

As the luminous efficiency of the blue sub-pixel is less than that of the red sub-pixel and that of the green sub-pixel, in order to normally display white light, both the effective light-emitting area of the red sub-pixel and the effective light-emitting area of the green sub-pixel is less than that of the blue sub-pixel.

In order to match the effective light-emitting area and the luminous efficiency, the effective light-emitting area $S_R$ of the red sub-pixel : the effective light-emitting area $S_G$ of the green sub-pixel : the effective light-emitting area $S_B$ of the blue sub-pixel = $R_2R_3 : R_1R_3 : R_1R_2$, in which $R_1$ indicates luminous efficiency of the red sub-pixel; $R_2$ indicates luminous efficiency of the green sub-pixel; and $R_3$ indicates luminous efficiency of the blue sub-pixel.

As the lengths of the red sub-pixel, the green sub-pixel and the blue sub-pixel are the same, the width $L_1$ of the red sub-pixel : the width $L_2$ of the green sub-pixel : the width $L_3$ of the blue sub-pixel = $(S_R+T_1) : (S_G+T_2) : (S_B+T_3)$, in which $T_1$ indicates an area of a non-luminous region of the red sub-pixel; $T_2$ indicates an area of a non-luminous region of the green sub-pixel; and $T_3$ indicates an area of a non-luminous region of the blue sub-pixel.

In the embodiment of the present invention, as the luminous efficiency of the blue sub-pixel is lower, the area of the red sub-pixel and the area of the green sub-pixel are appropriately reduced and the area of the blue sub-pixel is increased, so that the red sub-pixel and the green sub-pixel are not provided with regions which are not utilized, and hence the aperture ratio of the pixel structure can be increased.

An embodiment of the present invention provides a display device, which comprises the foregoing organic electroluminescence array substrate and a package substrate arranged opposite to the array substrate. The display device may be an electronic paper display, a mobile terminal display, a television, an electronic reader or the like.

An embodiment of the present invention further provides a method for manufacturing an organic electroluminescence array substrate, which comprises:
the features of claim 3.

As the lengths of the red sub-pixels, the green sub-pixels and the blue sub-pixels are the same, forming the red sub-pixels, the green sub-pixels and the blue sub-pixels on the active backplane further comprises:

forming the red sub-pixels with the width L1, the green sub-pixels with the width L2 and the blue sub-pixels with the width L3 on the active backplane, wherein $L_1:L_2:L_3 = (S_R+T_1) : (S_G+T_2) : (S_B+T_3)$ and $S_R : S_G : S_B = R_2R_3 : R_1R_3 : R_1R_2$, in which $S_R$ indicates an effective light-emitting area of the red sub-pixel; $S_G$ indicates an effective light-emitting area of the green sub-pixel; $S_B$ indicates an effective light-emitting area of the blue sub-pixel; $T_1$ indicates an area of a non-luminous region of the red sub-pixel; $T_2$ indicates an area of a non-luminous region of the greens sub-pixel; $T_3$ indicates an area of a non-luminous region of the blue sub-pixel; $R_1$ indicates luminous efficiency of the red sub-pixel; $R_2$ indicates luminous efficiency of the green sub-pixel; and $R_3$ indicates luminous efficiency of the blue sub-pixel.

Detailed description will be given below to the organic electroluminescence array substrate of the present invention with reference to the accompanying drawings and the preferred embodiments.

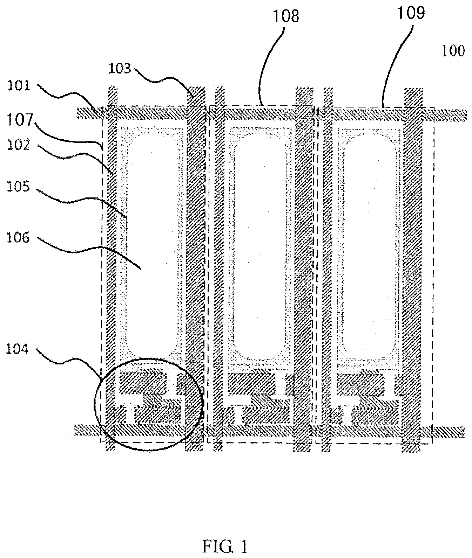

FIG. 1 is a schematic diagram illustrating the arrangement of pixels in an organic electroluminescence device in the traditional display device. As illustrated in FIG. 1, the organic electroluminescence array substrate comprises an active backplane 100, and a plurality of scanning lines 101 parallel to each other, a plurality of data lines 102 parallel to each other and a plurality of power lines 103 are formed on the active backplane. The scanning lines 101 and the data lines 102 are perpendicular to each other to define sub-pixel regions; the defined sub-pixel regions include red sub-pixels 107, green sub-pixels 108 and blue sub-pixels 109. These three types of sub-pixels are adjacently and repeatedly arranged in the order of red, green and blue; and the red sub-pixel 107, the green sub-pixel 108 and the blue sub-pixel 109 which are adjacent to each other are arranged to form a pixel unit. Each sub-pixel includes an organic electroluminescence device 106; and correspondingly, the red sub-pixel, the green sub-pixel and the blue sub-pixel are respectively provided with luminescent devices capable of emitting red light, green light and blue light. Moreover, each sub-pixel further includes a driving transistor, a switching transistor and a capacitor, in which a drain electrode of the driving transistor is electrically connected with the power line 103; a source electrode of the driving transistor is electrically connected with an anode 105 of the organic electroluminescence device; a gate electrode of the driving transistor is electrically connected with a drain electrode of the switching transistor; one end of the capacitor is electrically connected with the gate electrode of the driving transistor and the other end of the capacitor is electrically connected with the source electrode of the driving transistor. A gate electrode of the switching transistor is electrically connected with the scanning line; and a source electrode of the switching transistor is electrically connected with the data line.

As illustrated in FIG. 1, in the traditional sub-pixel design, both the width and the length of the red sub-pixels, the green sub-pixels and the blue sub-pixels are the same, and the areas of opaque circuit regions 104 in the three types of sub-pixels are basically the same as well. As the luminous efficiency of the blue sub-pixel is less than that of the red sub-pixel and that of the green sub-pixel, in order to normally display white light, the effective light-emitting area of the blue sub-pixel would be greater than that of the red sub-pixel and that of the green sub-pixel. In the case where the red sub-pixel, the green sub-pixel and the blue sub-pixel have different effective light-emitting areas, the sub-pixel design is limited by the blue sub-pixel with the greatest effective light-emitting area, and hence the red sub-pixel and the green sub-pixel are certainly provided with regions which do not emit light and do not belong to opaque circuit areas, and consequently the aperture ratio of the red sub-pixel and the green sub-pixel is reduced.

In order to solve the above-mentioned problem, in an embodiment of the present invention, the ratio of the effective light-emitting area of various sub-pixels is obtained at first according to the matching conditions of red light, green light and blue light and the factors such as luminous efficiency, service life and the like of organic electroluminescence devices for emitting red light, green light and blue light respectively. The ratio of the effective light-emitting area of the red sub-pixel, the green sub-pixel and the blue sub-pixel can be obtained by the following formula:

$$S_R : S_G : S_B = R_2R_3 : R_1R_3 : R_1R_2,$$

in which $R_1$ indicates luminous efficiency of the red sub-pixel; $R_2$ indicates luminous efficiency of the green sub-pixel; and $R_3$ indicates luminous efficiency of the blue sub-pixel.

After the ratio of the effective light-emitting areas of the red sub-pixel, the green sub-pixel and the blue sub-pixel is obtained, the dimension of the red sub-pixel and the green sub-pixel can be appropriately reduced and the dimension of the blue sub-pixel can be increased by the adjustment upon the areas of the red sub-pixel, the green sub-pixel and the blue sub-pixel according to the ratio.

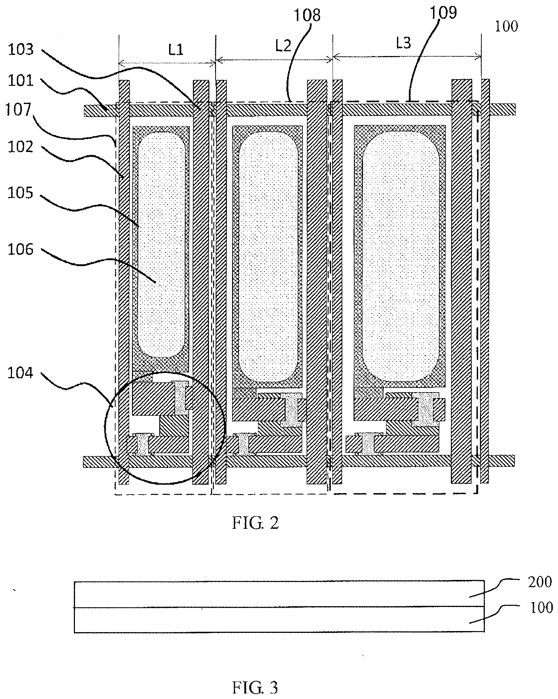

FIG. 2 is a schematic diagram illustrating the pixel arrangement of an organic electroluminescence device in the embodiment of the present invention. As illustrated in FIG. 2, the organic electroluminescence array substrate comprises an active backplane 100, wherein a plurality of scanning lines 101 parallel to each other, a plurality of data lines 102 parallel to each other and a plurality of power lines 103 are formed on the active backplane; the scanning lines 101 and the data lines 102 are perpendicular to each other to define sub-pixel regions; the defined sub-pixel regions include red sub-pixels 107, green sub-pixels 108 and blue sub-pixels 109; these three types of sub-pixels are adjacently and repeatedly arranged in the order of red, green and blue; and the red sub-pixel 107, the green sub-pixel 108 and the blue sub-pixel 109 which are adjacent to each other are arranged to form a pixel unit. The present invention is not limited to the arrangement modes of the red, green and blue sub-pixels in the pixel unit.

Each sub-pixel includes an organic electroluminescence device 106. Correspondingly, the red sub-pixel, the green sub-pixel and the blue sub-pixel are respectively provided with luminescent devices capable of emitting red light, green light and blue light respectively. Moreover, each sub-pixel at least further includes a driving transistor, a switching transistor and a capacitor, in which a drain electrode of the driving transistor is electrically connected with the power line 103; a source electrode of the driving transistor is electrically connected with an anode 105 of the organic electroluminescence device; a gate electrode of the driving transistor is electrically connected with a drain electrode of the switching transistor; one end of the capacitor is electrically connected with the gate electrode of the driving transistor and the other end of the capacitor is electrically connected with the source electrode of the driving transistor; a gate electrode of the switching transistor is electrically connected with the scanning line; and a source electrode of the switching transistor is electrically connected with the data line.

As illustrated in FIG. 2, when the red sub-pixel, the green sub-pixel and the blue sub-pixel are arranged side by side, both the length and the width of a pixel unit are represented by L; the widths of the red sub-pixel, the green sub-pixel and the blue sub-pixel of the pixel unit are respectively represented by $L_1$, $L_2$ and $L_3$; the area of a non-luminous region of the red sub-pixel is represented by $T_1$; the area of a non-luminous region of the green sub-pixel is represented by $T_2$; the area of a non-luminous region of the blue sub-pixel is represented by $T_3$; and hence the ratio of the red sub-pixel width to the green sub-pixel width to the blue sub-pixel width, namely $L_1:L_2:L_3$, can be obtained by the following formula: $L_1:L_2:L_3 = (S_R+T_1) : (S_G+T_2) : (S_B+T_3)$.

As the luminous efficiency of the blue sub-pixel is less than that of the red sub-pixel and that of the green sub-pixel, in order to normally display white light, the effective light-emitting area of the blue sub-pixel must be greater than that of the red sub-pixel and that of the green sub-pixel. In the embodiment of the present invention, where the luminous efficiency of the blue sub-pixel is lower, the areas of the red sub-pixel and the green sub-pixel are reduced and the area of the blue sub-pixel is increased according to the ratio of the luminous efficiency, so that the red sub-pixel and the green sub-pixel are not provided with regions which are not utilized, and hence the aperture ratio of a pixel structure can be increased.

An embodiment of the present invention provides a display device. As illustrated in FIG. 3, the display device comprises an organic electroluminescence array substrate 100 and a package substrate 200 arranged opposite to the array substrate 100. The package substrate 200 covers a surface of the array substrate 100 in such a way that the array substrate 100 is isolated from outside moisture and oxygen, and hence the service life of the display device can be prolonged.

The foregoing is only the preferred embodiments of the present invention and not intended to limit the scope of protection of the present invention. The scope of protection of the present invention is defined by the appended claims.

**Claims**

1. An organic electroluminescence array substrate, comprising an active backplane (100) and a color display layer formed on the active backplane (100), wherein
   the color display layer includes a plurality of pixel units;
   each pixel unit includes a red sub-pixel (107), a green sub-pixel (108) and a blue sub-pixel (109), in which both the area of the red sub-pixel (107) and the area of the green sub-pixel (108) are less than the area of the blue sub-pixel (109), wherein the lengths of the red sub-pixel (107), the green sub-pixel (108) and the blue sub-pixel (109) are the same, and wherein both the width of the red sub-pixel and the width of the green sub-pixel are less than the width of the blue sub-pixel;
   both the effective light-emitting area of the red sub-pixel and the effective light-emitting area of the green sub-pixel are less than the effective area of the blue sub-pixel;
   **characterized in that,**
   the effective light-emitting area $S_R$ of the red sub-pixel (107), the effective light-emitting area $S_G$ of the green sub-pixel (108) and the effective light-emitting area $S_B$ of the blue sub-pixel (109) are such that $S_R : S_G : S_B = R_2R_3 : R_1R_3 : R_1R_2$, in which $R_1$ indicates the luminous efficiency of the red sub-pixel (107); $R_2$ indicates the luminous efficiency of the green sub-pixel (108); and $R_3$ indicates the luminous efficiency of the blue sub-pixel (109); and the width $L_1$ of the red sub-pixel (107), the width $L_2$ of the green sub-pixel (108) and the width $L_3$ of the blue sub-pixel (109) are such that $L_1 : L_2 : L_3 = (S_R+T_1) : (S_G+T_2) : (S_B+T_3)$, in which $T_1$ indicates the area of the non-luminous region of the red sub-pixel (107); $T_2$ indicates the area of the non-luminous region of the green sub-pixel (108); and $T_3$ indicates the area of the non-luminous region of the blue sub-pixel (109); $S_R$ indicates the effective light-emitting area of the red sub-pixel (107); $S_G$ indicates the effective light-emitting area of the green sub-pixel (108); and $S_B$ indicates the effective light-emitting area of the blue sub-pixel (109), wherein the non-luminous region is an opaque circuit region (104).

2. A display device, comprising the organic electroluminescence array substrate according to claim 1 and a package substrate arranged opposite to the array substrate.

3. A method for manufacturing an organic electroluminescence array substrate, comprising:

   providing an active backplane (100); and
   forming a color display layer on the active backplane (100), wherein the color display layer includes a plurality of pixel units, wherein each pixel unit includes a red sub-pixel (107), a green sub-pixel (108) and a blue sub-pixel (109), wherein both the area of the red sub-pixel (107) and the area of the green sub-pixel (108) are less than the area of the blue sub-pixel (109), and wherein forming the color display layer on the active backplane (100) comprises:

forming the red sub-pixels (107), the green sub-pixels (108) and the blue sub-pixels (109) with same lengths and different widths on the active backplane (100), in which both the width of the red sub-pixel (107) and the width of the green sub-pixel (108) are less than the width of the blue sub-pixel (109);

**characterized by**

forming the red sub-pixels (107), the green sub-pixels (108) and the blue sub-pixels (109) with same lengths and different widths on the active backplane (100) comprises:

forming the red sub-pixels (107) with the width L1, the green sub-pixels (108) with the width L2 and the blue sub-pixels (109) with the width L3 on the active backplane (100), wherein $L_1:L_2:L_3 = (S_R+T_1) : (S_G+T_2) : (S_B+T_3)$ and $S_R : S_G : S_B = R_2R_3 : R_1R_3 : R_1R_2$, in which $S_R$ indicates the effective light-emitting area of the red sub-pixels (107), $S_G$ indicates the effective light-emitting area of the green sub-pixels (108), $S_B$ indicates the effective light-emitting area of the blue sub-pixels (109), $T_1$ indicates the area of the non-luminous region of the red sub-pixels (107), $T_2$ indicates the area of the non-luminous region of the greens sub-pixels (108), $T_3$ indicates the area of the non-luminous region of the blue sub-pixels (109), $R_1$ indicates the luminous efficiency of the red sub-pixels (107), $R_2$ indicates the luminous efficiency of the green sub-pixels (108), and $R_3$ indicates the luminous efficiency of the blue sub-pixels (109), wherein the non-luminous region is an opaque circuit region (104).

## Patentansprüche

1. Organisches Elektrolumineszenz-Array-Substrat mit einer aktiven Rückwand (100) und einer auf der aktiven Rückwand (100) gebildeten Farbanzeigeschicht, wobei

die Farbanzeigeschicht eine Vielzahl von Pixel-Einheiten aufweist;

jede Pixel-Einheit ein rotes Sub-Pixel (107), ein grünes Sub-Pixel (108) und ein blaues Sub-Pixel (109) aufweist, wobei sowohl die Fläche des roten Sub-Pixels (107) als auch die Fläche des grünen Sub-Pixels (108) kleiner ist als die Fläche des blauen Sub-Pixels (109), wobei die Längen des roten Sub-Pixels (107), des grünen Sub-Pixels (108) und des blauen Sub-Pixels (109) gleich sind, und wobei sowohl die Breite des roten Sub-Pixels als auch die Breite des grünen Sub-Pixels kleiner als die Breite des blauen Sub-Pixels ist;

sowohl die effektive lichtemittierende Fläche des roten Sub-Pixels als auch die effektive lichtemittierende Fläche des grünen Sub-Pixels kleiner als die effektive Fläche des blauen Sub-Pixels sind;

**dadurch gekennzeichnet, dass**

die effektive lichtemittierende Fläche $S_R$ des roten Sub-Pixels (107), die effektive lichtemittierende Fläche $S_G$ des grünen Sub-Pixels (108) und die effektive lichtemittierende Fläche $S_B$ des blauen Sub-Pixels (109) derart sind, dass $S_R:S_G:S_B = R_2R_3 : R_1R_3 : R_1R_2$, wobei $R_1$ die Lichtausbeute des roten Sub-Pixels (107) anzeigt; $R_2$ die Lichtausbeute des grünen Sub-Pixels (108) anzeigt; und $R_3$ die Lichtausbeute des blauen Sub-Pixels (109) anzeigt; und

die Breite $L_1$ des roten Sub-Pixels (107), die Breite $L_2$ des grünen Sub-Pixels (108) und die Breite $L_3$ des blauen Sub-Pixels (109) derart sind, dass $L_1:L_2:L_3 = (S_R+T_1) : (S_G+T_2) : (S_B+T_3)$, wobei $T_1$ die Fläche eines nicht leuchtenden Bereichs des roten Sub-Pixels (107) anzeigt; $T_2$ die Fläche eines nicht leuchtenden Bereichs des grünen Sub-Pixels (108) anzeigt; und $T_3$ die Fläche eines nicht leuchtenden Bereichs des blauen Sub-Pixels (109) anzeigt; $S_R$ die effektive lichtemittierende Fläche des roten Sub-Pixels (107) anzeigt; $S_G$ die effektive lichtemittierende Fläche des grünen Sub-Pixels (108) anzeigt; und $S_B$ die effektive lichtemittierende Fläche des blauen Sub-Pixels (109) anzeigt, wobei der nicht leuchtende Bereich ein undurchsichtiger Schaltungsbereich (104) ist.

2. Anzeigevorrichtung mit der organischen Elektrolumineszenz-Array-Substrat nach Anspruch 1 und einem Gehäusesubstrat, das dem Array-Substrat gegenüberliegend angeordnet ist.

3. Verfahren zur Herstellung eines organischen Elektrolumineszenz-Array-Substrats, mit:

Bereitstellen einer aktiven Rückwand (100); und

Ausbilden einer Farbanzeigeschicht auf der aktiven Rückwandplatine (100), wobei die Farbanzeigeschicht eine Vielzahl von Pixel-Einheiten aufweist, wobei jede Pixel-Einheit ein rotes Sub-Pixel (107), ein grünes Sub-Pixel (108) und ein blaues Sub-Pixel (109) aufweist, wobei sowohl die Fläche des roten Sub-Pixels (107) als auch die Fläche des grünen Sub-Pixels (108) kleiner ist als die Fläche des blauen Sub-Pixels (109), und wobei das Ausbilden der Farbanzeigeschicht auf der aktiven Rückwandplatine (100) aufweist:

Ausbilden der roten Sub-Pixel (107), der grünen Sub-Pixel (108) und der blauen Sub-Pixel (109) mit gleichen Längen und unterschiedlichen Breiten auf der aktiven Rückwandplatine (100), wobei sowohl die Breite des roten Sub-Pixels (107) als auch die Breite des grünen Sub-Pixels (108) geringer ist als die Breite des blauen Sub-Pixels (109);

**gekennzeichnet durch**

Ausbilden der roten Sub-Pixel (107), der grünen Sub-Pixel (108) und der blauen Sub-Pixel (109) mit gleichen Längen und unterschiedlichen Breiten auf der aktiven Rückwandplatine (100) mit

Ausbilden der roten Sub-Pixel (107) mit der Breite $L_1$, der grünen Sub-Pixel (108) mit der Breite $L_2$ und der blauen Sub-Pixel (109) mit der Breite $L_3$ auf der aktiven Backplane (100), wobei $L_1:L_2:L_3 = (S_R+T_1) : (S_G+T_2) : (S_B+T_3)$ und $S_R : S_G : S_B = R_2R_3 : R_1R_3 : R_1R_2$, wobei $S_R$ die effektive lichtemittierende Fläche der roten Sub-Pixel (107) angibt, $S_G$ die effektive lichtemittierende Fläche der grünen Sub-Pixel (108) angibt, $S_B$ die effektive lichtemittierende Fläche der blauen Sub-Pixel (109) angibt, $T_1$ die Fläche eines nicht leuchtenden Bereichs der roten Sub-Pixel (107) angibt, $T_2$ die Fläche eines nicht leuchtenden Bereichs der grünen Sub-Pixel (108) angibt, $T_3$ die Fläche eines nicht leuchtenden Bereichs der blauen Sub-Pixel (109) anzeigt, $R_1$ die Lichtausbeute der roten Sub-Pixel (107) anzeigt, $R_2$ die Lichtausbeute der grünen Sub-Pixel (108) anzeigt, und $R_3$ die Lichtausbeute der blauen Sub-Pixel (109) anzeigt, wobei der nicht leuchtende Bereich ein undurchsichtiger Schaltungsbereich (104) ist.

## Revendications

1. Substrat de matrice électroluminescent organique, comprenant un plan arrière actif (100) et une couche d'affichage en couleur qui est formée sur le plan arrière actif (100), dans lequel :

   la couche d'affichage en couleur inclut une pluralité d'unités de pixel ;
   chaque unité de pixel inclut un sous-pixel rouge (107), un sous-pixel vert (108) et un sous-pixel bleu (109), dans lequel l'aire du sous-pixel rouge (107) et l'aire du sous-pixel vert (108) sont toutes deux plus petites que l'aire du sous-pixel bleu (109), dans lequel les longueurs du sous-pixel rouge (107), du sous-pixel vert (108) et du sous-pixel bleu (109) sont les mêmes, et dans lequel la largeur du sous-pixel rouge et la largeur du sous-pixel vert sont toutes deux plus petites que la largeur du sous-pixel bleu ;
   l'aire électroluminescente effective du sous-pixel rouge et l'aire électroluminescente effective du sous-pixel vert sont toutes deux plus petites que l'aire électroluminescente effective du sous-pixel bleu ;
   **caractérisé en ce que** :

   l'aire électroluminescente effective $S_R$ du sous-pixel rouge (107), l'aire électroluminescente effective $S_G$ du sous-pixel vert (108) et l'aire électroluminescente effective $S_B$ du sous-pixel bleu (109) sont telles que $S_R : S_G : S_B = R_2R_3 : R_1R_3 : R_1R_2$, où $R_1$ représente l'efficacité lumineuse du sous-pixel rouge (107) ; $R_2$ représente l'efficacité lumineuse du sous-pixel vert (108) ; et $R_3$ représente l'efficacité lumineuse du sous-pixel bleu (109) ; et
   la largeur $L_1$ du sous-pixel rouge (107), la largeur $L_2$ du sous-pixel vert (108) et la largeur $L_3$ du sous-pixel bleu (109) sont telles que $L_1 : L_2 : L_3 = (S_R + T_1) : (S_G + T_2) : (S_B + T_3)$, où $T_1$ représente l'aire de la région non lumineuse du sous-pixel rouge (107) ; $T_2$ représente l'aire de la région non lumineuse du sous-pixel vert (108) ; et $T_3$ représente l'aire de la région non lumineuse du sous-pixel bleu (109) ; $S_R$ représente l'aire électroluminescente effective du sous-pixel rouge (107) ; $S_G$ représente l'aire électroluminescente effective du sous-pixel vert (108) ; et $S_B$ représente l'aire électroluminescente effective du sous-pixel bleu (109), dans lequel la région non lumineuse est une région de circuit opaque (104).

2. Dispositif d'affichage, comprenant le substrat de matrice électroluminescent organique selon la revendication 1 et un substrat de conditionnement sous module qui est agencé à l'opposé du substrat de matrice.

3. Procédé pour fabriquer un substrat de matrice électroluminescent organique, comprenant :

   la fourniture d'un plan arrière actif (100) ; et
   la formation d'une couche d'affichage en couleur sur le plan arrière actif (100), dans lequel la couche d'affichage en couleur inclut une pluralité d'unités de pixel, dans lequel chaque unité de pixel inclut un sous-pixel rouge (107), un sous-pixel vert (108) et un sous-pixel bleu (109), dans lequel l'aire du sous-pixel rouge (107) et l'aire du sous-pixel vert (108) sont toutes deux plus petites que l'aire du sous-pixel bleu (109), et dans lequel la formation de la couche d'affichage en couleur sur le plan arrière actif (100) comprend :

la formation des sous-pixels rouges (107), des sous-pixels verts (108) et des sous-pixels bleus (109) selon les mêmes longueurs et selon des largeurs différentes sur le plan arrière actif (100), dans lequel la largeur du sous-pixel rouge (107) et la largeur du sous-pixel vert (108) sont toutes deux plus petites que la largeur du sous-pixel bleu (109) ;

**caractérisé en ce que** :

la formation des sous-pixels rouges (107), des sous-pixels verts (108) et des sous-pixels bleus (109) selon les mêmes longueurs et selon des largeurs différentes sur le plan arrière actif (100) comprend :

la formation des sous-pixels rouges (107) selon la largeur $L_1$, des sous-pixels verts (108) selon la largeur $L_2$ et des sous-pixels bleus (109) selon la largeur $L_3$ sur le plan arrière actif (100), dans lequel $L_1 : L_2 : L_3 = (S_R + T_1) : (S_G + T_2) : (S_B + T_3)$ et $S_R : S_G : S_B = R_2 R_3 : R_1 R_3 : R_1 R_2$, où $S_R$ représente l'aire électroluminescente effective des sous-pixels rouges (107), $S_G$ représente l'aire électroluminescente effective des sous-pixels verts (108), $S_B$ représente l'aire électroluminescente effective des sous-pixels bleus (109), $T_1$ représente l'aire de la région non lumineuse des sous-pixels rouges (107), $T_2$ représente l'aire de la région non lumineuse des sous-pixels verts (108), $T_3$ représente l'aire de la région non lumineuse des sous-pixels bleus (109), $R_1$ représente l'efficacité lumineuse des sous-pixels rouges (107), $R_2$ représente l'efficacité lumineuse des sous-pixels verts (108) et $R_3$ représente l'efficacité lumineuse des sous-pixels bleus (109), dans lequel la région non lumineuse est une région de circuit opaque (104).

FIG. 1

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004051448 A1
- EP 1032045 A2
- US 2010117528 A1
- EP 1758170 A2
- US 2006114190 A1
- WO 2012132862 A1
- US 2012313844 A1
- EP 2472583 A2
- JP 2006244892 A